# EUROPEAN PATENT SPECIFICATION

(11) **EP 0 453 867 B1**
(45) Date of publication and mention of the grant of the patent: **10.08.1994**
(21) Application number: 91105626.5
(22) Date of filing: 09.04.1991
(51) Int. Cl.: F16K 51/02, F16K 1/10

(54) **Slit valve apparatus and method**
Vorrichtung und Verfahren für Schlitzventil
Appareil et procédé de vanne à fente

(30) Priority: 20.04.1990 US 511658
(43) Date of publication of application: 30.10.1991
(73) Proprietor: APPLIED MATERIALS, INC., Santa Clara, California 95052-8039 (US)
(72) Inventor: Tepman, Avi, Cupertino, California 95014 (US); Andrews, Dana L., Mountain View, California 94043 (US)
(74) Representative: Kahler, Kurt, Dipl.-Ing.

(56) References cited:
- EP-A- 0 242 997
- US-A- 4 166 607

## Description

### Background of the Invention

This invention relates generally to slit valve assemblies and methods and more particularly to slit valve assemblies and methods used in semiconductor manufacturing equipment.

Semiconductor manufacturing equipment often include a number of adjacent but independently sealable chambers. For example, a single piece of semiconductor manufacturing equipment might include a number of processing chambers and one or more load-lock chambers clustered around a central robotic transfer chamber. To pass a semiconductor wafer between chambers elongated apertures or "slits" are provided in the walls between the chambers. These apertures can be selectively opened or closed by means of slit valves.

There are a great many types of slit valves known in the prior art. For example, in U.S. patent 4,785,962 of *Toshima* a vacuum chamber slit valve is disclosed which includes a door pivotally mounted near an aperture and pneumatically actuated cam follower rollers which selectively pivot the door between an open and closed position. Another approach is taken by *Hutchinson* in U.S. patent 4,715,764 who teaches a gate valve having an angularly disposed seat portion and a mating angular closure portion which moves vertically towards the seat portion. A third approach is disclosed in Vacuum Valves 90, May 1, 1989, pp. 24-29, a product catalog of VAT, Inc. VAT, Inc. provides a rectangular valve having a stepped seat which is engaged by a mating gate which moves perpendicularly with respect to the aperture.

There are several problems with gate valves of the prior art. Firstly, they all include bearing surfaces within the chamber which can generate particulates by surface-to-surface friction Secondly, the force required to hold the gate valves in their closed position tends to be relatively large because the closing force is always at an angle to the seat surface. In consequence, considerable force must be applied to the doors of prior art slit valves to properly seal them against their valve seats.

### Summary of the Invention

It is therefore an object of this invention to provide a gate valve assembly which requires less sealing force than prior art gate valve assemblies and which does not have any particulate producing friction surfaces within the chamber with which it is associated.

The apparatus of the present invention includes a chamber wall defining an aperture through which integrated circuit wafers may be passed along a transfer plane. The slit valve assembly further includes a seat surrounding the aperture and having a first seating surface defining a seating plane which is angularly disposed with respect to the transfer plane and a door having a second seating surface matingly engageable with the first seating surface. Finally, the slit valve apparatus includes a linear actuator mechanism for linearly moving the door towards and away from the seat along an actuator axis substantially perpendicular to the seating plane. The frictionally engaged portions of the linear actuator mechanism are enclosed within an expansible bellow sleeve to isolate all frictionally engaged surfaces from the interior of the chamber.

The method of the present invention involves surrounding an elongated aperture with a first sealing surface defining a sealing plane which is angularly disposed with respect to a transfer plane extending through said aperture and engaging or disengaging a second seating surface with the first seating surface by linearly moving the second seating surface in a direction substantially perpendicular to the sealing plane. The orientation of the first seating surface and the second seating surface is adjusted by deactivating a locking mechanism which locks the position of the second seating surface, engaging the first and second seating surfaces, and then reactivating the locking mechanism.

An advantage of the present invention is that the opening and closing motion of the door is linear and perpendicular to the valve seat. Since the all of the force applied to the door is normal to the seating surfaces less pressure needs to be applied to the door to provide an effective seal.

Another advantage of the present invention is that all frictional surfaces are isolated from the interior of the chamber by the bellow sleeve. This dramatically reduces particulate formation which can increase the yield of wafers processed within the semiconductor manufacturing equipment.

These and other advantages of the present invention will become clear to those skilled in the art upon a study of the detailed description of the invention and of the several figures of the drawings.

### Brief Description of the Drawings

*Figure 1* is a partial cross-sectional elevational view of a slit valve apparatus in accordance with the present invention with the slit valve in a closed position;
*Figure 2* is the same view as Fig. 1 with the slit valve in an open position; and
*Figure 3* is an exploded isometric view of the adjustable support for the valve door of the present invention.

### Detailed Description of the Preferred Embodiments

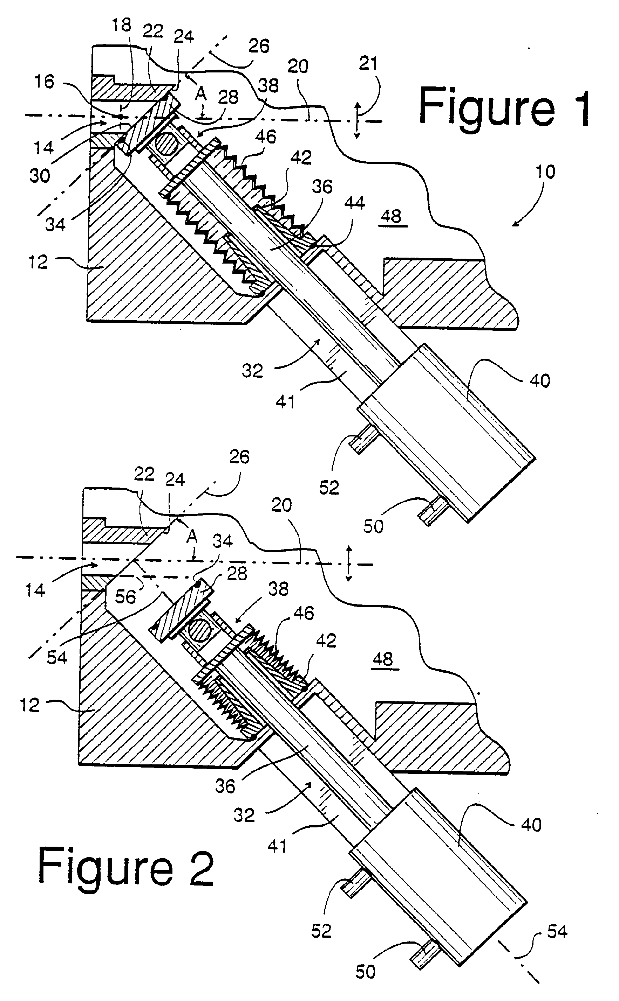

In Fig. 1, a slit valve apparatus 10 in accordance with the present invention includes a chamber wall 12 provided with an aperture 14 having a major axis 16 perpendicular to the plane of the paper and having a minor axis 18. The aperture 14 is adapted to pass an object, such as an integrated circuit wafer, substantially parallel to a transfer plane 20 which is parallel to the major axis 16 and perpendicular to the minor axis 18. As suggested by the arrow 21, the object can also be moved through aperture 14 along any plane parallel to transfer plane 20 or close to parallel to transfer plane 20. A seat 22 includes a first seating surface 24 which defines a sealing plane 26 which is angularly disposed with respect to the transfer plane 20. A door 28 has a second seating surface 30 which is matingly engageable with the first seating surface 24 along sealing plane 26. The door 28 is coupled to a linear actuator mechanism 32. An O-ring seal 34 is provided on door 28 to provide effective sealing between the door 28 and the seat 22.

The linear actuator mechanism 32 includes an elongated shaft 36, an adjustment mechanism 38 coupling a first end of the shaft 36 to door 28 and a reciprocal linear drive mechanism 40 coupled to a second end of shaft 36. The mechanism 40 is rigidly coupled to the wall 12 by a bracket 41. A shaft guide 42 is coupled to wall 12 and an O-ring 44 is provided to seal the shaft guide 42 to the wall. An expansible bellow sleeve 46 is sealed at one end to the adjustment mechanism 38 and at the other end to shaft guide 42. As such, the sliding frictional engagement between shaft 36 and the shaft guide 42 is isolated from the interior 48 of the chamber. The linear drive mechanism is preferably a commercially available pneumatic actuator which causes the shaft 36 to move away from the mechanism 40 when air pressure is applied to a first inlet 50 and away from the mechanism 40 when air pressure is applied to a second inlet 52.

In Fig. 2, air pressure has been applied to inlet 52 causing the door 28 to move linearly away from sealing plane 26 along an actuator axis 54 which is substantially perpendicular to the sealing plane 26. The shaft guide 42 serves as a stop to limit the motion of the shaft 36 towards the linear drive mechanism 40. The door 28 can be biased towards an open position, a closed position, or some intermediate position by an appropriate biasing mechanism (not shown).

It should be noted that all friction creating surfaces are isolated from the interior 48 of the chamber by the bellow sleeve 46. It is therefore very unlikely that the slit valve apparatus 10 will produce any particulates within the chamber interior 48, thereby eliminating a potential source of contamination. It should also be noted that the linear drive mechanism 40 delivers all of its force along actuator axis 54 perpendicularly to the valve seat 22. This not only reduces the amount of force which must be applied by the actuator mechanism 32, but it also minimizes rubbing between the O-ring 34 and the first seating surface 24, thereby reducing particulate generation and O-ring wear.

The angle A between the transfer plane 20 and the sealing plane 26 is preferably in the range of 30° - 60° and is most preferably approximately 45°. If the angle A becomes much greater than about 60° the stroke of the shaft 36 must become very long to allow the door 28 to clear the bottom plane 56 of the aperture 14. If the angle A becomes much less than 30° the first seating surface 24 will become excessively large promoting possible leakage and requiring larger pressures to be exerted by the linear drive mechanism 40. An angle A of 45° is a good compromise between excessive stroke length of the shaft 36 and moderate closing pressure required of linear drive mechanism 40.

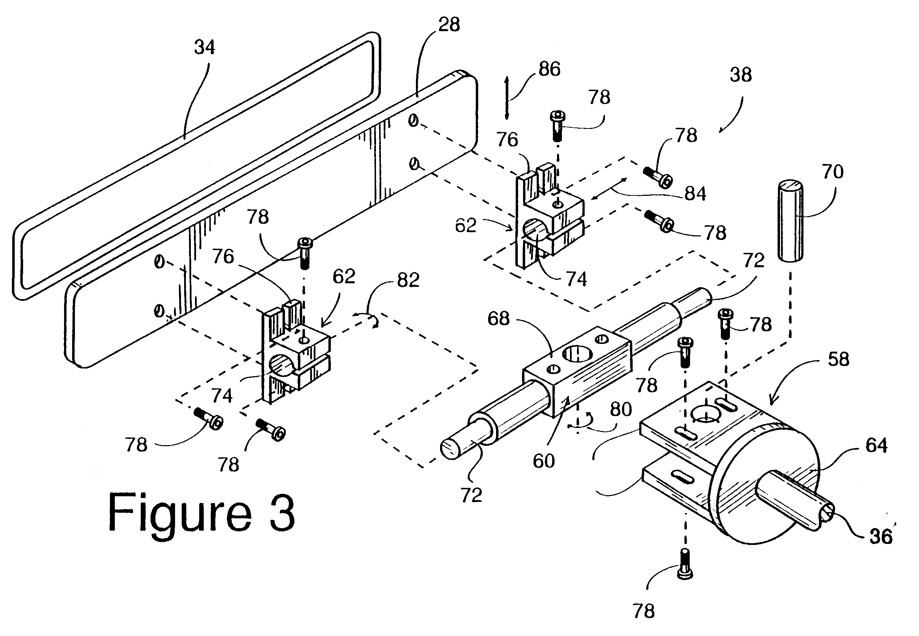

In Fig. 3, an exploded isometric view of the adjustment mechanism 38 shows a bracket assembly 58, an axle 60 and a pair of axle bearings 62. A circular plate 64 of the bracket assembly is attached to shaft 36 and sealed to bellow sleeve 46 and a pair of fingers 66 engage a central portion 68 of axle 60 by means of a pivot pin 70. Bearing surfaces 72 of axle 60 engage bores 74 of the axle bearings 62. Ears 76 of the axle bearings 62 are attached to the door 28. A number of machine screws 78 create a locking mechanism for locking the position of the door 28 relative to shaft 36 and for holding the adjustment mechanism 38 together.

The adjustment mechanism 38 permits four separate adjustments to be made to the position of the door 28 relative to valve seat 22. A first adjustment 80 adjusts the left-right angular position of the door 28. A second adjustment 82 adjusts the up-down angular position of the door. A third adjustment 84 adjusts the left-right linear position of the door 28 relative the valve seat 22. Finally, a fourth adjustment 86 adjusts the up-down linear position of the door 28.

To properly adjust the door 28 to the valve seat 22, the screws 78 are loosened and the door 28 is closed by applying air pressure to inlet 50 of the linear drive mechanism 40. The angular adjustments 80 and 82 are made automatically by the pressing of the first seating surface 24 against the second seating surface 30 and the linear adjustments 84 and 86 are made manually, if necessary. Once the door 28 is properly positioned, the screws 78 are tightened to lock the door 28 into position. It should be noted that once the adjustment mechanism 38 is locked there are no moving parts to cause friction within the chamber interior 48.

While this invention has been described in terms of several preferred embodiments, it is contemplated that various alterations and permutations thereof will become apparent to those skilled in the art. It is therefore intended that the appended claims include all such alterations and permutations as fall within the scope of the present invention.

## Claims

1. A slit valve apparatus (10) comprising:
- wall means (12) defining an aperture (14) having a major axis (16) and a minor axis (18), said aperture (14) being adapted to pass an object along a transfer plane (20) substantially parallel to said major axis (16) and perpendicular to said minor axis (18);
- seat means (22) surrounding said aperture (14), said seat means (22) having a first seating surface (24) defining a sealing plane (26) which is angularly disposed with respect to said transfer plane (20);
- door means (28) having a second seating surface (30) which is matingly engageable with said first seating surface (24) along said sealing plane (26); and
- linear actuator means (32) for selectively moving said door means (28) towards and away from said seat means (22) along an actuator axis (54) which is substantially perpendicular to said sealing plane (26).

2. The apparatus of claim 1, wherein the included angle between said transfer plane (20) and said sealing plane (26) is in the range of 30° - 60°, preferably about 45°.

3. The apparatus of claim 1 or 2, wherein said linear actuator means (32) includes an elongated shaft (36) coupled at a first end to said door means (28) and coupled at a second end to a reciprocal linear drive mechanism (40), preferably a pneumatically actuated mechanism.

4. The apparatus of claim 3, wherein said shaft (36) passes through said wall means and further comprising guide means (42) coupled to said wall means (12) for guiding said shaft (36) along said actuator axis (54) and enclosure means (46) coupling said first end of said shaft (36) to said wall means (12).

5. The apparatus of any preceding claim, further comprising multi-axis adjustment means (38) coupling said first end of said shaft (36) to said door means (28).

6. The apparatus of claim 4 or 5, wherein said enclosure means comprises a bellows (46) coupled at a first end to said shaft (36) and coupled at a second end to said wall means (12).

7. The apparatus of any preceding claim, further comprising first sealing means (34) disposed between said first seating surface and said second seating surface and/or second sealing means (44) disposed between said bellow (46) and said wall means (12).

8. A method for selectively opening or closing an elongated aperture (14) provided in a wall (12) through which objects may be passed substantially parallel to a transfer plane (20) comprising the steps of:
- surrounding said aperture (14) with a first seating surface (24) defining a sealing plane (28) which is angularly disposed with respect to said transfer plane (20); and
- engaging or disengaging a second seating surface (30) with said first seating surface (24) by linearly moving said second seating surface (30) in a direction substantially perpendicular to said sealing plane (28).

9. The method of claim 8, further comprising the step of adjusting the orientation of said first seating surface (24) and said second seating surface (30) such that they are substantially parallel and such that said aperture (14) is completely covered by said second seating surface (30) when said second seating surface (30) is engaged with said first seating surface (24).

10. The method of claim 9, wherein said step of adjusting said orientation is accomplished by:
- deactivating locking means (78) which locks the position of said second seating surface (30);
- engaging said first seating surface (24) and said second seating surface (30); and
- reactivating said locking means (78).

## Patentansprüche

1. Eine Schlitzventilvorrichtung (10), aufweisend:
- eine Wandeinrichtung (12), die eine Öffnung (14) mit einer Hauptachse (16) und einer Nebenachse (18) festlegt, wobei die Öffnung (14) angepaßt ist, einen Gegenstand längs einer im wesentlichen zur Hauptachse (16) parallelen und zur Nebenachse (18) senkrechten Transportebene (20) durchgehen zu lassen;
- eine Sitzeinrichtung (22), die die Öffnung (14) umgibt, wobei die Sitzeinrichtung (22) eine erste Sitzfläche (24) aufweist, die eine bezüglich der Transportebene (20) unter einem Winkel angeordnete Dichtungsebene (26) bestimmt;
- eine Türeinrichtung (28) mit einer zweiten Sitzfläche (30), die mit der ersten Sitzfläche (24) längs der Dichtungsebene (26) passend in Eingriff steht; und
- eine Linearbetätigungseinrichtung (32) zum wahlweisen Bewegen der Türeinrichtung (28) längs einer Betätigungsachse (54), die im wesentlichen senkrecht zu der Dichtungsebene (26) verläuft, auf die Sitzeinrichtung (22) zu und von dieser weg.

2. Die Vorrichtung nach Anspruch 1, wobei
der zwischen der Transportebene (20) und der Dichtungsebene (26) eingeschlossene Winkel im Bereich von 30° - 60°, vorzugsweise bei etwa 45° liegt.

3. Die Vorrichtung nach Anspruch 1 oder 2, wobei die Linearbetätigungseinrichtung (32) einen länglichen Schaft (36) einschließt, der an einem ersten Ende mit der Türeinrichtung (28) und an einem zweiten Ende mit einem Umkehr-Linearantriebsmechanismus (40), vorzugsweise einem pneumatisch betätigten Mechanismus gekoppelt ist.

4. Die Vorrichtung nach Anspruch 3, wobei der Schaft (36) durch die Wandeinrichtung hindurchläuft und ferner aufweisend eine Führungseinrichtung (42), die mit der Wandeinrichtung (12) zum Führen des Schafts (36) längs der Betätigungsachse (54) gekoppelt ist, und eine Verkleidungseinrichtung (46), die das erste Ende des Schafts (36) mit der Wandeinrichtung (12) koppelt.

5. Die Vorrichtung nach einem vorhergehenden Anspruch, ferner aufweisend eine Mehrachsen-Einstelleinrichtung (38), die das erste Ende des Schafts (36) mit der Türeinrichtung (28) koppelt.

6. Die Vorrichtung nach Anspruch 4 oder 5, wobei die Verkleidungseinrichtung einen Balg (46) aufweist, der an einem ersten Ende mit dem Schaft (36) und an einem zweiten Ende mit der Wandeinrichtung (12) gekoppelt ist.

7. Die Vorrichtung nach einem vorhergehenden Anspruch, ferner aufweisend eine erste Dichtungseinrichtung (34), die zwischen der ersten Sitzfläche und der zweiten Sitzfläche und/oder der zweiten Dichtungseinrichtung (44) angeordnet ist, die zwischen dem Balg (46) und der Wandeinrichtung (12) angeordnet ist.

8. Ein Verfahren zum wahlweisen Öffnen oder Schließen einer länglichen Öffnung (14), die in einer Wand (12) vorgesehen ist, durch die Gegenstände im wesentlichen parallel zu einer Transportebene (20) hindurchgelangen, aufweisend die Schritte:
- Umgeben der Öffnung (14) mit einer ersten Sitzfläche (24), die eine Dichtungsebene (28) bildet, die bezüglich der Transportebene (20) unter einem Winkel angeordnet ist; und
- in Eingriff bringen einer zweiten Sitzfläche (30) bezüglich der ersten Sitzfläche (24) bzw. diese außer Eingriff bringen durch lineares Bewegen der zweiten Sitzfläche (30) in einer zu der Dichtungsebene (28) im wesentlichen senkrechten Richtung.

9. Das Verfahren nach Anspruch 8,
ferner aufweisend den Schritt des Einstellens der Ausrichtung der ersten Sitzfläche (24) und der zweiten Sitzfläche (30) derart, daß diese im wesentlichen parallel zueinander sind und derart, daß die Öffnung (14) vollständig durch die zweite Sitzfläche (30) abgedeckt wird, wenn die zweite Sitzfläche (30) mit der ersten Sitzfläche (24) in Eingriff steht.

10. Das Verfahren nach Anspruch 9,
wobei der Schritt des Einstellens der Ausrichtung durchgeführt wird durch:
- Deaktivieren einer Fixierungseinrichtung (78), die die Stellung der zweiten Sitzfläche (30) festlegt;
- in Eingriff bringen der ersten Sitzfläche (24) und der zweiten Sitzfläche (30); und
- Reaktivieren der Fixierungseinrichtung (78).

## Revendications

1. Appareil de vanne à fente (10) comprenant des moyens de paroi (12) définissant une ouverture (14) présentant un axe principal (16) et un axe mineur (18), ladite ouverture (14) étant destinée au passage d'un objet le long d'un plan de transfert (20) essentiellement parallèle audit axe principal (16) et perpendiculaire audit axe mineur (18); des moyens de siège (22) entourant ladite ouverture (14), lesdits moyens de siège (22) présentant une première surface d'appui (24) définissant un plan d'étanchéité (26) qui est disposé de manière angulaire par rapport audit plan de transfert (20); des moyens de porte (28) présentant une seconde surface d'appui (30) qui peut s'engager avec conjugaison de forme avec ladite première surface d'appui (24) le long dudit plan d'étanchéité (26); et des moyens de commande linéaires (32) destinés à approcher et à éloigner de manière sélective lesdits moyens de porte (28) desdits moyens de siège (22) le long d'un axe de commande (54) qui est essentiellement perpendiculaire audit plan d'étanchéité (26).

2. Appareil selon la revendication 1, dans lequel l'angle inclus entre ledit plan de transfert (20) et ledit plan d'étanchéité (26) est compris entre 30° et 60°, de préférence environ 45°.

3. Appareil selon la revendication 1 ou 2, dans lequel lesdits moyens de commande linéaires (32) incluent un arbre allongé (36) couplé en une première extrémité auxdits moyens de porte (28) et couplé à l'autre extrémité à un mécanisme d'entraînement linéaire réciproque (40), de préférence un mécanisme actionné de manière pneumatique.

4. Appareil selon la revendication 3, dans lequel ledit arbre (36) passe à travers lesdits moyens de paroi et comprenant également des moyens de guidage (42), couplés auxdits moyens de paroi (12) pour guider ledit arbre (36) le long dudit axe de commande (54) et des moyens d'inclusion (46) couplant ladite première extrémité dudit arbre (36) auxdits moyens de paroi (12).

5. Appareil selon l'une des revendications précédentes, comprenant également des moyens de réglage multi-axiaux (38) couplant ladite première extrémité dudit arbre (36) auxdits moyens de porte (28).

6. Appareil selon la revendication 4 ou 5, dans lequel lesdits moyens d'inclusion comprennent un soufflet (46) couplé en une première extrémité audit arbre (36) et couplé en une seconde extrémité auxdits moyens de paroi (12).

7. Appareil selon l'une des revendications précédentes, comprenant également des premiers moyens d'étanchéité (34) disposés entre ladite première surface d'appui et ladite seconde surface d'appui et/ou des seconds moyens d'étanchéité (44) disposés entre ledit soufflet (46) et lesdits moyens de paroi (12).

8. Méthode destinée à ouvrir ou à fermer de manière sélective une ouverture allongée (14) disposée dans une paroi (12) à travers laquelle des objets peuvent être passés, de manière essentiellement parallèle à un plan de transfert (20), comprenant les étapes consistant à: entourer ladite ouverture (14) avec une première surface d'appui (24) définissant un plan d'étanchéité (28) qui est disposé de manière angulaire par rapport audit plan de transfert (20); et à engager ou à désengager une seconde surface d'appui (30) d'avec ladite première surface d'appui (24) en déplaçant linéairement ladite seconde surface d'appui (30) dans une direction essentiellement perpendiculaire audit plan d'étanchéité (28).

9. Méthode selon la revendication 8, comprenant également l'étape consistant à ajuster l'orientation de ladite première surface d'appui (24) et de ladite seconde surface d'appui (30) de manière à ce qu'elles soient essentiellement parallèles et de manière à ce que l'ouverture (14) soit complètement recouverte par ladite seconde surface d'appui (30) lorsque ladite seconde surface d'appui (30) est engagée avec ladite première surface d'appui (24).

10. Méthode selon la revendication 9, dans laquelle l'étape consistant à ajuster ladite orientation est effectuée en : désactivant les moyens de verrouillage (78) qui verrouillent la position de ladite seconde surface d'appui (30); en engageant ladite première surface d'appui (24) et ladite seconde surface d'appui (30); et en réactivant lesdits moyens de verrouillage (78).
